# EUROPÄISCHE PATENTSCHRIFT

(11) **EP 1 602 625 B1**
(45) Veröffentlichungstag und Bekanntmachung des Hinweises auf die Patenterteilung: **05.12.2007**
(21) Anmeldenummer: 05090155.2
(22) Anmeldetag: 30.05.2005
(51) Int. Cl.: B81B 7/00, H01L 23/31

(54) **Halbleitermodul mit einem Halbleiter-Sensorchip und einem Kunststoffgehäuse sowie Verfahren zu dessen Herstellung**
Semiconductor module with a semiconductor sensor and a plastic package and its method of fabrication.
Module à semiconducteur avec un capteur à semiconducteur et un empaquetage en plastique et son procédé de fabrication.

(30) Priorität: 02.06.2004 DE 102004027094
(43) Veröffentlichungstag der Anmeldung: 07.12.2005
(73) Patentinhaber: Infineon Technologies AG, 81669 München (DE)
(72) Erfinder: Auburger, Albert, 93128 Regenstauf (DE); Koller, Adolf, 93059 Regensburg (DE); Paulus, Stefan, 93197 Zeitlarn (DE)
(74) Vertreter: Dilg, Haeusler, Schindelmann Patentanwaltsgesellschaft mbH

(56) Entgegenhaltungen:
- DE-A1- 10 208 635
- DE-A1- 19 640 255
- DE-A1- 19 754 616
- DE-B3- 10 246 283
- US-B1- 6 624 921
- BUTLER J T ET AL: "EXTENSION OF HIGH DENSITY INTERCONNECT MULTICHIP MODULE TECHNOLOGY FOR MEMS PACKAGING" PROCEEDINGS OF THE SPIE, SPIE, BELLINGHAM, VA, US, Bd. 3224, 29. September 1997 (1997-09-29), Seiten 169-177, XP009014670 ISSN: 0277-786X

## Beschreibung

Die Erfindung betrifft ein Halbleitermodul mit einem Halbleiter-Sensorchip und einem Kunststoffgehäuse sowie Verfahren zu dessen Herstellung. Das Sensorchip dieses Halbleitermoduls weist einen Sensorbereich auf und steht mit mindestens einer weiteren Komponente des Halbleitermoduls elektrisch in Verbindung, dabei ist mindestens die weitere Komponente in eine Kunststoffmasse eingebettet.

Ein derartiges Halbleitermodul ist aus der Patentanmeldung DE 103 30 739.7 bekannt. In dieser bekannten Ausführungsform eines Halbleitermoduls ist zwar die weitere Komponente, ein Halbleiterchip, in eine nicht transparente Kunststoffgehäusemasse eingebettet jedoch ist der gesamte Sensorchip mit seinen elektrischen Verbindungen freizugänglich und somit der Umgebung ausgesetzt. Ein derartiges Halbleitermodul hat den Nachteil, dass die empfindlichen elektrischen Verbindungen einer übermäßigen Belastung nicht standhalten insbesondere nicht bei hohen Temperaturwechselbelastungen wie sie in der KFZ-Technik gefordert werden. Dort ergeben sich Probleme der Zuverlässigkeit derartiger Halbleitermodule mit frei zugänglichem Sensorchip.

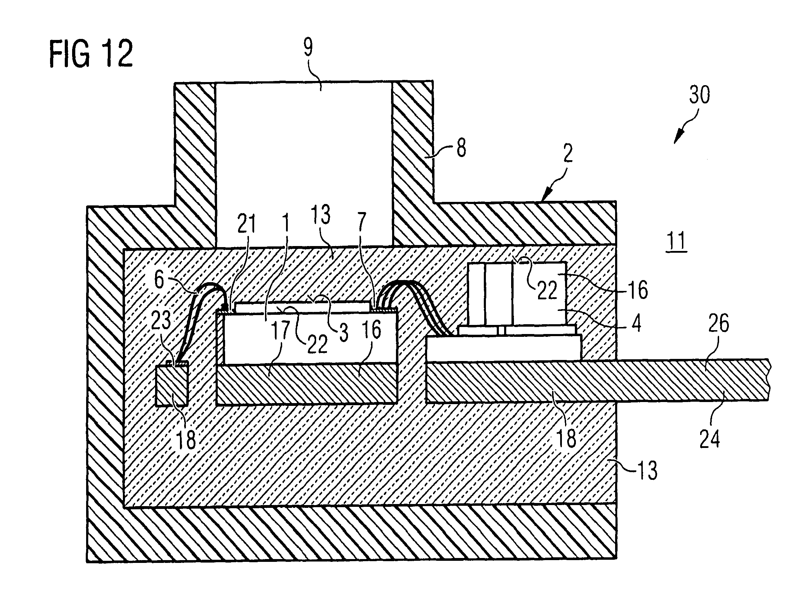

Um diese Probleme zu überwinden wird eine Lösung vorgeschlagen, wie sie in Figur 12 abgebildet ist.

Figur 12 zeigt ein Halbleitermodul 30 des Standes der Technik, bei dem der Sensorchip 1 vollständig in einer Kunststoffmasse aus transparentem Material 13 zusammen mit einer weiteren Komponente 4 eingebettet ist. Diese Kunststoffmasse wird von einem Gehäuse 2 aus einer nicht transparenten Kunststoffmasse 8 umgeben. Die Komponenten 16 dieses Halbleitermoduls 30 sind auf Chipinseln 17 von Innenflachleitern 18 angeordnet, wobei Bonddrahtverbindungen 19 die elektrischen Verbindungen 6 zwischen Kontaktflächen 21 der aktiven Oberseiten 22 der Komponenten zu Außenkontakten 24 in Form von Außenflachleitern 26 über die Innenflachleiter 18 herstellen. Dazu weisen die Innenflachleiter 18 Kontaktanschlussflächen 23 für die Bonddrahtverbindung 19 auf.

Bei diesem Halbleiterbauteil mit einem optischen Sensorchip 1 sind zwar der Sensorchip und auch weitere Komponenten des Halbleitermoduls durch das transparente Material geschützt, jedoch ist der Aufbau derart komplex dass bei extremen Temperaturzyklen, wie sie im Test für die KFZ-Technik eingesetzt werden, das umhüllende transparente Material 13 in Zusammenwirken mit der gemoldeten nicht transparenten Kunststoffgehäusemasse 8 Probleme bereitet, sodass eine zuverlässige optische Kopplung über die Öffnung 9 in der nicht transparenten Kunststoffgehäusemasse 8 nicht gewährleistet wird.

Darüber hinaus beschreibt die DE 102 46 283 B3 ein Halbleitermodul mit einem Halbleiter-Sensorchip, der einen Sensorbereich aufweist. Die nicht-sensitiven Bereiche des Sensorchips sind in einer nicht transparenten Kunststoffgehäusemasse eingebettet.

Aufgabe der Erfindung ist es ein Halbleitermodul mit einem Halbleitersensorchip und mit einem Gehäuse zu schaffen, das die oben im Stand der Technik erwähnten Probleme vermindert, einen zuverlässigen Zugriff auf den Sensor ermöglicht und in einfacher Weise herstellbar ist.

Gelöst wird diese Aufgabe mit dem Gegenstand der unabhängigen Ansprüche. Vorteilhafte Weiterbildungen der Erfindung ergeben sich aus den abhängigen Ansprüchen.

Erfindungsgemäß wird ein Halbleitermodul und ein Verfahren zu seiner Herstellung geschaffen, wobei das Halbleitermodul einen Halbleiter-Sensorchip und ein Gehäuse aufweist. Der Sensorchip weist in dem Gehäuse einen Sensorbereich auf, und steht mit mindestens einer weiteren Komponente des Halbleitermoduls in Form eines Halbleiterchips oder eines passiven Bauelementes elektrisch in Verbindung. Diese elektrischen Verbindungen, die weitere Komponente und die nicht sensitiven Bereiche des Sensorchips sind in einer nicht transparenten Kunststoffgehäusemasse eingebettet. Der Sensorbereich des Sensorchips steht jedoch über eine Öffnung in der nicht transparenten Kunststoffgehäusemasse mit der Umgebung in Wirkverbindung, wobei die Öffnung einen Laserabtragstrichter aufweist.

Ein Vorteil dieses Halbleitermoduls ist es, dass keine speziellen Moldwerkzeuge zum Molden von Kavitäten bzw. zum Molden von Holraumgehäusen erforderlich sind. Ferner kann, da erst nachträglich die Öffnung eines Laserabtragstrichters geschaffen wird, das Auftreten eines Moldflash in den zu schaffenden Kavitäten für Halbleitersensorbauteile vermieden werden. Weiterhin ist es von Vorteil, dass der Laserabtragstrichter bis in die gewünschte Tiefe bzw. bis zur aktiven Chipoberfläche, dem Sensorbereich, erfolgen kann, ohne diesen Sensorbereich zu beschädigen. Dazu werden die Materialunterschiede zwischen den absorbierenden nicht transparenten Kunststoffmaterialen und der laserreflektierenden Oberfläche eines Halbleitersensorbereichs ausgenutzt.

Das Freiliegen der Öffnung mittels Lasertechnik ist somit unproblematisch. Ein weiterer Vorteil des Halbleitermoduls liegt in der Nutzung des schwarzen, vollumspritzenden Moldverbundes. Die Zuverlässigkeit dieser Verpackungstechnologie ist erwiesen und hält den neuen Anforderungen an optische und mechanische Sensoren insbesondere in der KFZ-Technik stand.

Weiterhin wird die Zuverlässigkeit dieses Sensormoduls durch den Einsatz nur eines einzigen Materials für die Umhüllung der Bauteilkomponenten weiter verbessert. Schließlich werden durch die Umhüllung der nicht sensitiven Bereiche des Sensorchips mit der nicht transparenten Kunststoffgehäusemasse diese Bereiche des Sensorchips besonders geschützt und im Halbleitermodul derart fixiert, dass das erfindungsgemäße Halbleitermodul extreme Temperaturschwankungen, wie sie in der KFZ-Technik auftreten, unbeschädigt überstehen kann. Halbleitermodule mit einem derartigen Gehäuse und einem Laserabtragstrichter, der den Einfluss der Umgebung auf den Sensorbereich des Sensorchips begrenzt haben sich selbst bei extremen Temperaturzyklen bestens bewährt.

Zum Schutz der Oberfläche des Sensorbereichs vor einer aggressiven Umgebung kann der Laserabtragstrichter mit einem transparenten Material teilweise aufgefüllt sein. Die Dicke dieses transparenten Materials ist so bemessen, dass die optischen Eigenschaften einer Empfängerdiode oder einer Sendediode nicht beeinträchtigt werden. Für mikromechanische und drucksensitive Halbleitermodule kann der Laserabtragstrichter mit einem gummielastischen und transparenten Material aufgefüllt sein. Das gummielastische Material wird für Druckempfindliche Sensoren eingesetzt, da es in vorteilhafter Weise die Druckmessung nicht verfälscht.

In einer weiteren Ausführungsform der Erfindung sind die Komponenten des Halbleitermoduls stoffschlüssig auf Chipinseln von inneren Flachleitern fixiert. Diese stoffschlüssige Fixierung auf metallischen Flachleitern hat sich insbesondere in der KFZ-Technik bewährt, zumal über diese inneren Flachleiter Wärme nach Außen abgegeben werden kann. Für weniger temperaturbelastete Halbleitermodule ist es auch möglich die Halbleiterchips stoffschlüssig auf Chipinseln eines Verdrahtungssubstrats eines BGA- oder LGA-Gehäuses zu fixieren. Diese Verdrahtungs- und Anschlusstechnologie hat sich jedoch in der KFZ-Technik noch nicht durchgesetzt, zumal über ein Verdrahtungssubstrat die Wärmeabfuhr problematischer ist als über metallische Flachleiter.

Die oben erwähnten elektrischen Verbindungen werden vorzugsweise als Bonddrahtverbindungen ausgeführt. Diese Bonddrahtverbindungen verbinden elektrisch Kontaktflächen der aktiven Oberseiten der Komponenten mit Kontaktanschlussflächen auf den inneren Flachleitern, wenn das Halbleitermodul auf einer Flachleitertechnik basiert oder mit Kontaktanschlussflächen auf dem Verdrahtungssubstrat, wenn das Halbleitermodul in einem BGA- oder LGA-Gehäuse eingebaut ist. Da die Bonddrahtverbindungen des Sensorchips vollständig in die nicht transparente Kunststoffgehäusemasse eingebettet sind, und auch nicht durch den Laserabtragstrichter freigelegt werden, ergibt sich ein Halbleitermodul, das eine hohe Festigkeit gegenüber mechanischen Belastungen und gegenüber thermomechanischen Spannungen aufweist.

Wird für das Halbleitermodul die Flachleitertechnik eingesetzt, so gehen die inneren Flachleiter in Außenflachleiter über, welche aus der Kunststoffgehäusemasse als Außenkontakte seitlich herausragen. Beim Einsatz eines Verdrahtungssubstrats für das Halbleitermodul sind die Komponenten einschließlich des Sensorchips auf der Oberseite des Verdrahtungssubstrats angeordnet, und auf der Unterseite des Verdrahtungssubstrats sind die Außenkontakte in Form von Lotbällen befestigt.

Die oben erwähnten stoffschlüssigen Verbindungen zwischen dem Halbleiterchip und den Chipinseln der Flachleitertechnik weisen vorzugsweise eine eutektische Lötverbindung auf. Derartige Lötverbindungen haben gegenüber Klebeverbindungen den Vorteil, einer höheren Temperaturfestigkeit, die insbesondere in der KFZ-Technik entscheidend ist. Um noch bessere Ergebnisse erzielen zu können, weisen die stoffschlüssigen Verbindungen Diffusionslötverbindungen auf. Bei derartigen Diffusionslötverbindungen entstehen intermetallische Phasen, deren Schmelzpunkt höher ist als die Temperatur beim Diffusionslötvorgang. Auch Lotpastenverbindungen bilden metallische Verbindungskomponenten, nachdem die flüchtigen Bestandteile der Lotpaste beim Zusammensintern zu einer stoffschlüssigen Verbindung entwichen sind.

Wie bereits mehrfach erwähnt, kann das erfindungsgemäße Halbleitermodul vorteilhaft als optischer Sensor und/oder optischer Empfänger in der KFZ-Technik und dort insbesondere über Glasfaserkabelbäume eingesetzt werden. Dabei hat es sich gezeigt, dass die hochkomplexen Lösungen, wie sie in Figur 12 gezeigt werden, den hohen Temperaturschwankungen mit denen im KFZ-Betrieb gerechnet werden muss nicht standhalten. Dem gegenüber hat sich jedoch der erfindungsgemäße einfache Aufbau für Halbleitermodule mit einem Halbleiter-Sensorchip bewährt. Neben der optischen Anwendung als Sender und/oder Empfänger kann ein derartiger Sensorchip auch als druck- oder temperaturempfindlicher Sensor ausgebildet sein und in der KFZ-Technik eine bevorzugte Verwendung finden.

Ein Verfahren zur Herstellung eines Halbleitermoduls mit einem Halbleiter- Sensorchip und einem Gehäuse weist die nachfolgenden Verfahrensschritte auf. Zunächst wird ein Systemträger mit Halbleiterchippositionen und Kontaktanschlussflächen für elektrische Verbindungen zu Außenkontakten für mindestens ein Halbleitermodul hergestellt. Nach dem Herstellen eines Systemträgers wird auf diesen ein Halbleiter-Sensorchip mit einem Sensorbereich und mindestens eine weitere Komponente in Form eines Halbleiterchips oder eines passiven Bauelementes durch stoffschlüssiges Verbinden der Komponenten mit dem Systemträger aufgebracht. Anschließend können elektrische Verbindungen zwischen Kontaktanschlussflächen des Systemträgers und Kontaktflächen der Komponenten hergestellt werden. Anschließend wird unter Einbetten der Komponenten und elektrischen Verbindungen eine nicht transparente.Kunststoffgehäusemasse aufgebracht, welche den Systemträger die Komponenten und die elektrischen Verbindungen umhüllt. Als letzter Schritt wird dann der Sensorbereich des Halbleiter-Sensorchips unter Bilden eines Laserabtragstrichters in der Kunststoffgehäusemasse mittels Laserabtragstechnik freigelegt.

Ein derartiges Verfahren hat den Vorteil, dass keine speziellen Moldwerkzeuge für den Zugriff auf den Sensorbereich des Sensorchips vorbereitet werden müssen. Vielmehr kann nach völliger Umhüllung des Sensorchips der Sensorbereich mit Hilfe der Laserabtragtechnik freigelegt werden, wobei die unterschiedliche Abtragsrate zwischen nicht transparentem Kunststoff und hochreflektierender Halbleiteroberfläche benutzt wird, um beschädigungsfrei den Sensorbereich des Halbleiter-Sensorchip freizulegen. In diesem Verfahren können nicht nur optische Sensorbereiche sondern auch Sensorbereiche für mechanische Parameter wie Druck und Kraft, sowie fluidsensitive Bereiche, die Gasanalysen und Flüssigkeitsanalysen ermöglichen und temperaturempfindliche Bereiche von Halbleiterchips freigelegt werden.

Bei einem bevorzugten Durchführungsbeispiel des Verfahrens wird für einen Laserabtrag ein Lasergerät und eine Spiegeltrommel mit polygonalem Querschnitt eingesetzt. Dabei dreht sich die Spiegeltrommel um eine horizontale Längsachse, während das Lasergerät oder ein Planspiegel im Laserstrahl um eine Hochachse geschwenkt werden, um den Laserstrahl entlang der Spiegeltrommel- Längserstreckung abzulenken. Anstelle der Spiegeltrommel kann auch ein um eine horizontale Achse schwenkbarer Planspiegel eingesetzt werden. Durch diese zweidimensionale Ablenkung des Laserstrahls wird eine flächige Abtastung bzw. ein Abtrag erreicht, sodass eine Öffnung über den Sensorbereich hergestellt werden kann. Andere Aufbauten derartiger Laserabtragstechniken sind möglich, jedoch wird die Spiegelablenkung bevorzugt eingesetzt um einen Laserabtragstrichter über dem empfindlichen Sensorbereich des Halbleiter- Sensorchips herzustellen.

Der Systemträger ist geeignet, um mehrere Halbleiter in entsprechenden Halbleitermodulpositionen des Systemträgers herzustellen. Dazu weist ein derartiger Systemträger in Zeilen und Spalten angeordnete Halbleitermodulpositionen auf. Basiert das Halbleitermodul auf einem Verdrahtungssubstrat, so kann für mehrere Halbleitermodule ein Nutzen eingesetzt werden. Andererseits ist bei einer Flachleitertechnik der Systemträger ein Flachleiterrahmen, aus dem die einzelnen Halbleitermodule nach Fertigstellung der Laserabtragsöffnung herausgestanzt werden. Sowohl der Nutzen als auch der Flachleiterrahmen haben den Vorteil, dass ein Grossteil der Fertigungsschritte parallel für mehrere Halbleitermodule gleichzeitig erfolgen kann.

Zusammenfassend ist festzustellen, dass durch die Erzeugung einer Öffnung in einem vollständig umspritzten Gehäuse in vorteilhafter Weise ein Zugriff auf den Sensorbereich eines Halbleiter- Sensorchips geschaffen werden kann, während alle übrigen Komponenten des Halbleitermoduls unter dem Schutz einer nicht transparenten Kunststoffgehäusemasse verbleiben. Der Kern der Erfindung besteht somit in einer Prozessverbesserung durch herausschneiden einer Öffnung in einem bereits vollständig Umspritzten Gehäuse. Dabei werden gleichzeitig alle nicht sensitiven Bereiche des Sensorchips und sämtliche nicht sensitiven Komponenten des Halbleitermoduls vor mechanischen Beschädigungen und thermomechanischen Spannungen geschützt.

Die Erfindung wird nun anhand der beigefügten Figuren näher erläutert.
- Figur 1: zeigt einen schematischen Querschnitt durch ein Halbleitermodul gemäß einer ersten Ausführungsform der Erfindung;
- Figuren 2 bis 7: zeigen schematische Querschnitte von Komponenten im Rahmen der Herstellung eines Halbleitermoduls gemäß Figur 1;

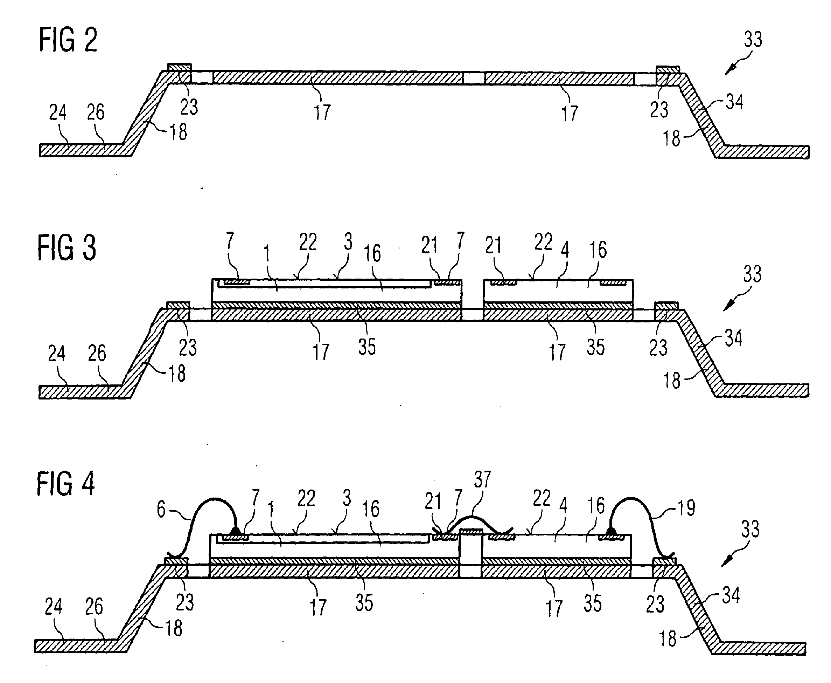

- Figur 2: zeigt einen schematischen Querschnitt einer Halbleitermodulposition eines Flachleiterrahmens;

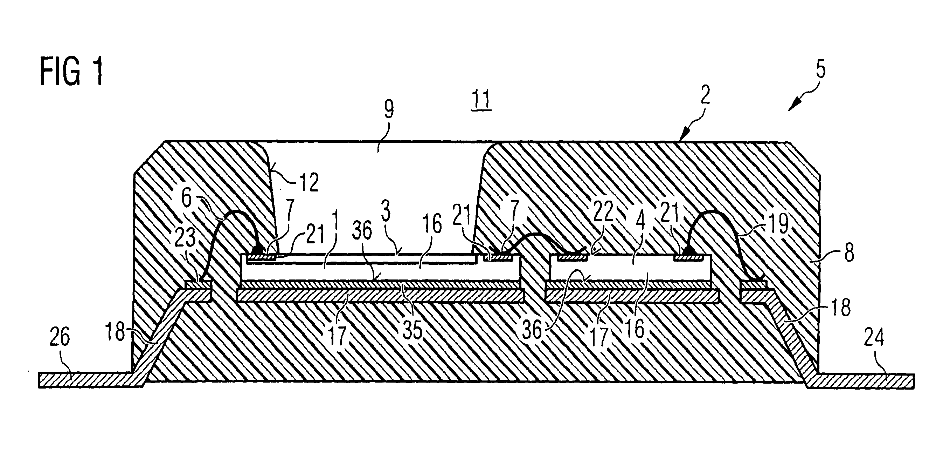

- Figur 3: zeigt einen schematischen Querschnitt der Halbleitermodulposition gemäß Figur 1 nach Aufbringen von Halbleiterchips bzw. nach Aufbringen von Komponenten;
- Figur 4: zeigt einen schematischen Querschnitt durch eine Halbleitermodulposition gemäß Figur 3 nach Aufbringen von Bonddrahtverbindungen;

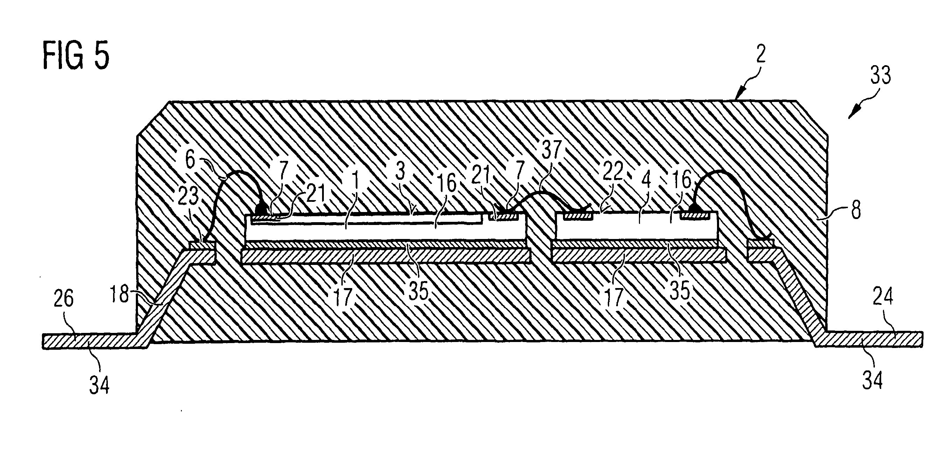

- Figur 5: zeigt einen schematischen Querschnitt der Halbleitermodulposition gemäß Figur 4 nach Aufbringen einer nicht transparenten Kunststoffgehäusemasse;

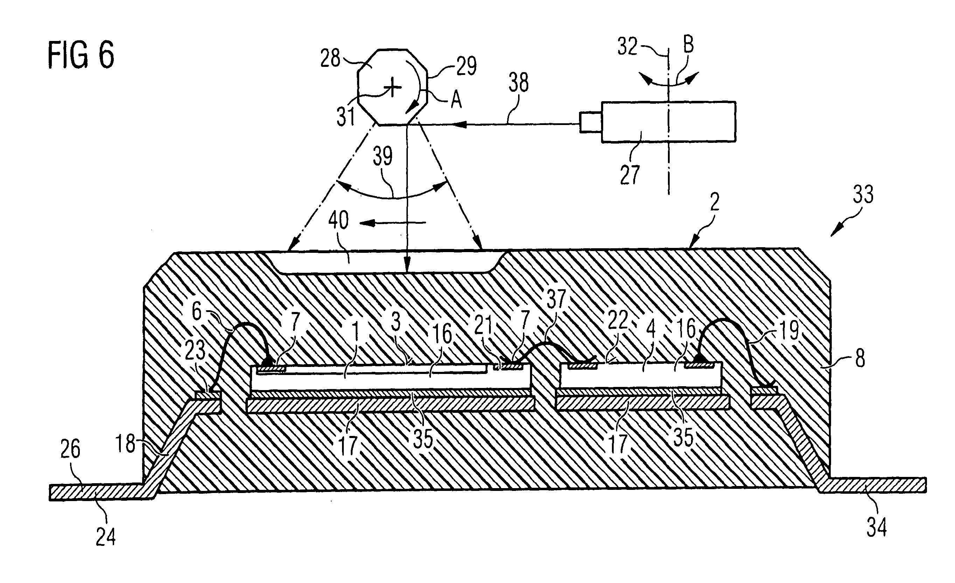

- Figur 6: zeigt einen schematischen Querschnitt der Halbleitermodulposition gemäß Figur 5 während eines Laserabtrages;

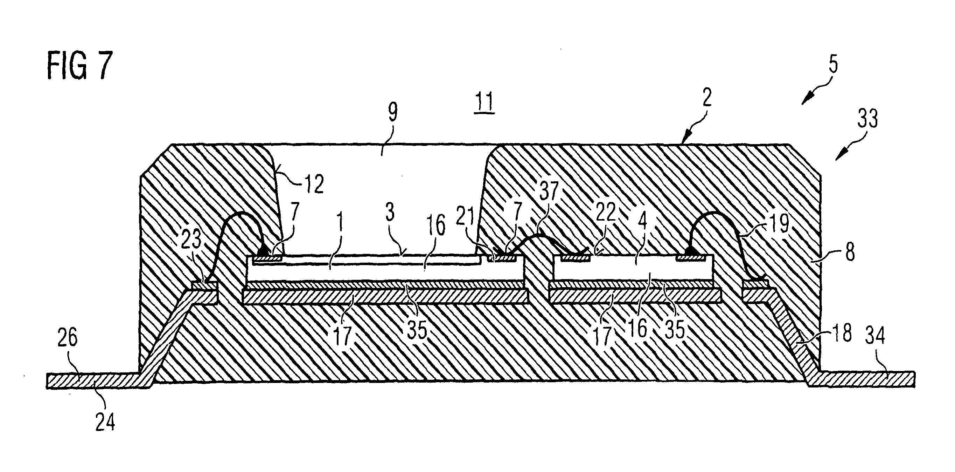

- Figur 7: zeigt einen schematischen Querschnitt der Halbleitermodulposition gemäß Figur 6 nach Freilegen des Sensorbereichs des Halbleitersensorchips;

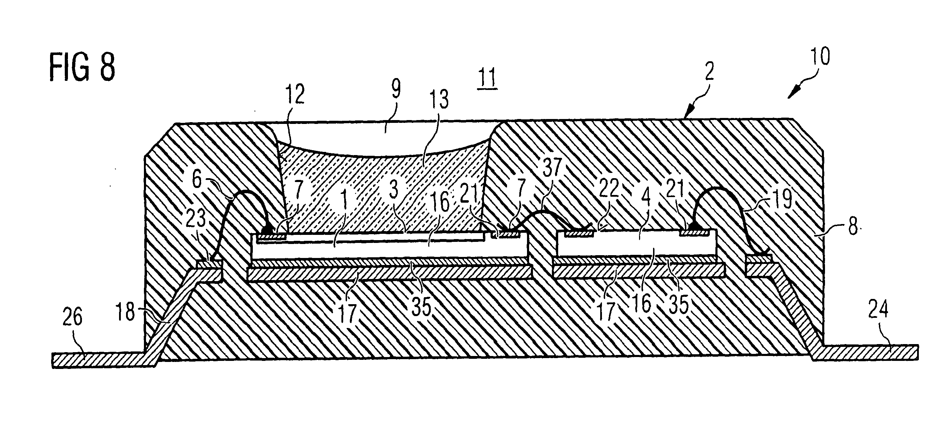

- Figur 8: zeigt einen schematischen Querschnitt durch ein Halbleitermodul gemäß einer zweiten Ausführungsform der Erfindung;

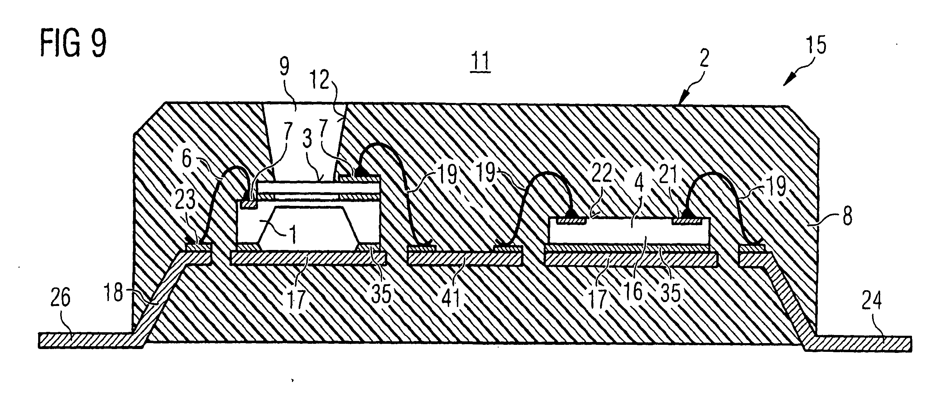

- Figur 9: zeigt einen schematischen Querschnitt durch ein Halbleitermodul gemäß einer dritten Ausführungsform der Erfindung;

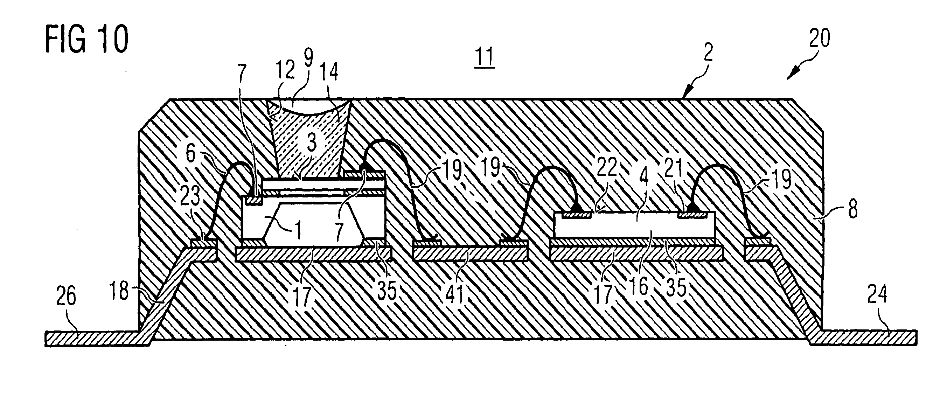

- Figur 10: zeigt einen schematischen Querschnitt durch ein Halbleitermodul gemäß einer vierten Ausführungsform der Erfindung;

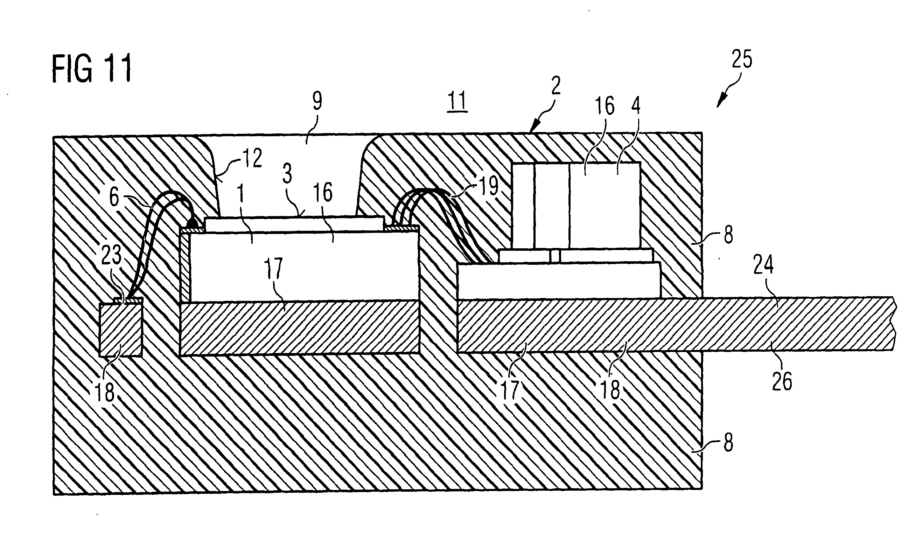

- Figur 11: zeigt einen schematischen Querschnitt durch ein Halbleitermodul gemäß einer fünften Ausführungsform der Erfindung;
- Figur 12: zeigt einen schematischen Querschnitt durch ein Halbleitermodul gemäß dem Stand der Technik.

Figur 1 zeigt einen schematischen Querschnitt durch ein Halbleitermodul 5 gemäß einer ersten Ausführungsform der Erfindung. Dieses Halbleitermodul 5 weist einen Sensorchip 1 und eine weitere Komponente 4 in Form eines Halbleiterchips auf, die auf Chipinseln 17 von Innenflachleitern 18 positioniert sind. Die Komponenten 16 sind mit ihren Rückseiten 36 stoffschlüssig durch eine Lotschicht 35 auf den Chipinseln 17 fixiert. Elektrische Verbindungen 6 in Form von Bonddrahtverbindungen 19 verbinden Kontaktflächen 21 der aktiven Oberseite 22 der Komponenten 16 mit Kontaktanschlussflächen 23 auf inneren Flachleitern 18.

Die inneren Flachleiter 18 gehen nach Außen in Außenflachleiter 24 über und bilden Außenkontakte 26. Die Komponenten 16 des Halbleitermoduls 5, wie die Halbleiterchips, die Bonddrahtverbindungen 19, die Innenflachleiter 18 und die Chipinseln 17 sind in einer nicht transparente Kunststoffmasse 8 eingebettet. Von dem Sensorchip 1 sind die nicht sensitiven Bereiche 7 ebenfalls von der Kunststoffgehäusemasse 8 umgeben während der Sensorbereich 3 durch eine Öffnung 9 für die Umgebung 11 freizugänglich ist. Dazu weist das Gehäuse 2 dieser ersten Ausführungsform der Erfindung einen Laserabtragstrichter 12 auf, der lediglich einen Zugriff auf den Sensorbereich 3 des Halbleiter-Sensorchips 1 zulässt. Somit sind insbesondere die empfindlichen Bonddrahtverbindungen 19 vor mechanischer Beschädigung und vor thermomechanischen Spannungen geschützt.

Die Figuren 2 bis 7 zeigen schematische Querschnitte von Komponenten im Rahmen der Herstellung eines Halbleitermoduls 5 gemäß Figur 1. Komponenten mit gleichen Funktionen, wie in Figur 1, werden in den Figuren 2 bis 7 mit gleichen Bezugszeichen gekennzeichnet und nicht extra erörtert.

Figur 2 zeigt einen schematischen Querschnitt einer Halbleitermodulposition 33 eines Flachleiterrahmens 34. Diese Halbleitermodulposition 33 weist zwei Chipinseln 17 auf, die mit den Innenflachleitern 18 elektrisch verbunden sind, wobei die Innenflachleiter 18 gekröpft bzw. abgewinkelt sind und in Außenflachleiter 24 des Flachleiterrahmens 34 übergehen. Die Außenflachleiter 24 bilden gleichzeitig Außenkontakte 26 für das Halbleitermodul.

Figur 3 zeigt einen schematischen Querschnitt der Halbleitermodulposition 33 gemäß Figur 1 nach Aufbringen von Halbleiterchips. Dazu wird auf eine der Chipinseln 17 der Sensorchip 1 mit einem Sensorbereich 3 aufgebracht, wobei der Sensorchip 1 in seinen nicht sensitiven Randbereichen 7 Kontaktflächen 21 aufweist. Der Sensorchip 1 wird auf der Chipinsel 17 durch eine eutektische Lotverbindung fixiert, sodass er für das anschließende Herstellen von Bonddrahtverbindungen zwischen den Kontaktflächen 21 des Sensorchips 1 und Kontaktanschlussflächen 23 der inneren Flachleiter 18 positioniert ist.

Die Kontaktanschlussflächen 23 können eine Veredelungsbeschichtung aufweisen, um das Bonden zu erleichtern. Dabei ist die Kombination Aluminium und Gold von Vorteil, weil das Zweiphasensystem Gold-Aluminium ein niedrig schmelzendes Eutektikum bildet und somit das Thermokompressions-Schallbonden erleichtert. Nach dem Fixieren der Halbleiterchips auf dem Flachleiterrahmen 34 in der Halbleitermodulposition 33 kann nun ein Bonden folgen.

Figur 4 zeigt einen schematischen Querschnitt der Halbleitermodulposition 33 gemäß Figur 3 nach Anbringen von Bonddrahtverbindungen 19. Die Bonddrahtverbindungen 19 verbinden nicht nur die Halbleiterchips mit den inneren Flachleitern 18 des Flachleiterrahmens 34, sondern können sich auch von Halbleiterchip zu Halbleiterchip, wie es die Bondverbindung 37 zeigt, erstrecken.

Figur 5 zeigt einen schematischen Querschnitt der Halbleitermodulposition 33 gemäß Figur 4 nach Aufbringen einer nicht transparenten Kunststoffgehäusemasse 8. Diese Kunststoffgehäusemasse 8 bettet sämtliche Komponenten wie die Komponenten, die Bonddrahtverbindungen 19 und 37 sowie die inneren Flachleiter 18 ein. Der Sensorbereich 3 des Sensorchips 1 ist nach diesem Verfahrensschritt nicht mehr zugänglich.

Figur 6 zeigt einen schematischen Querschnitt der Halbleitermodulposition 33 gemäß Figur 5 während eines Laserabtrags. Das Lasergerät 27 ist derart angeordnet, dass es horizontal einen Laserstrahl 38 emittiert, der auf eine sich in Pfeilrichtung A drehende Spiegeltrommel 28 fällt. Durch den polygonalen Querschnitt 29 der Spiegeltrommel 28 wird beim Drehen der Spiegeltrommel 28 um eine horizontale Längsachse 31 der Laserstrahl 38 in einem begrenzten Laserstrahlbereich 39 abgelenkt, sodass sich eine Kavität 40 in der nicht transparenten Kunststoffmasse 8 bildet. Diese Kavität 40 erstreckt sich zweidimensional, was dadurch erreicht werden kann, dass entweder das Lasergerät 27 um eine Hochachse 32 in Pfeilrichtung B oder im Laserstrahl 38 ein weiterer nicht gezeigter schwenkbarer Planspiegel um die Hochachse 32 hin und her geschwenkt wird, sodass die Spiegelflächen der Spiegeltrommel 28 parallel zu der horizontalen Längsachse 31 der Spiegeltrommel 28 bestrahlt werden. Daraus ergibt sich eine flächige Erstreckung des Laserstrahls 38, womit eine Öffnung in die Kunststoffgehäusemasse 8 eingegraben werden kann.

Figur 7 zeigt einen schematischen Querschnitt der Halbleitermodulposition 33 gemäß Figur 6 nach Freilegen des Sensorbereichs 3 des Halbleitersensorchips 1. Bei dem Laserabtrag, der auch in Figur 6 gezeigt wird, bildet sich in der Kunststoffgehäusemasse 8 über dem Sensorbereich 3 eine Öffnung 9 in Form eines Laserabtragstrichters 12 aus. Dieser Laserabtragstrichter 12 hat den Vorteil, dass er sehr präzise in die Kunststoffgehäusemasse 8 eingebracht werden kann, und dass die nicht sensitiven Bereiche 7 des Sensorchips durch die Kunststoffgehäusemasse 8 geschützt bleiben.

Figur 8 zeigt einen schematischen Querschnitt durch ein Halbleitermodul 10 gemäß einer zweiten Ausführungsform der Erfindung. Komponenten mit gleichen Funktionen, wie in den vorhergehenden Figuren werden mit gleichen Bezugszeichen gekennzeichnet und nicht extra erörtert. Die zweite Ausführungsform der Erfindung unterscheidet sich von der ersten Ausführungsform der Erfindung gemäß Figur 1 dadurch, dass der Sensorbereich 3 dadurch geschützt wird, dass die Öffnung 9 mit einem optisch transparenten Material 13 teilweise aufgefüllt ist.

Figur 9 zeigt einen schematischen Querschnitt durch ein Halbleitermodul 15 gemäß einer dritten Ausführungsform der Erfindung. Komponenten mit gleichen Funktionen, wie in den vorhergehenden Figuren, werden mit gleichen Bezugszeichen gekennzeichnet und nicht extra erörtert. Die dritte Ausführungsform der Erfindung unterscheidet sich von den ersten beiden Ausführungsformen dadurch, dass ein Drucksensor realisiert wird, das einen mikromechanischen Sensor zur Aufnahme von Beschleunigungskräften und/oder Druckkräften aufweist. Dazu weist der Sensorchip 1 eine spezielle Brückenform auf und wird von einem Sensorplättchen abgedeckt.

Des weiteren weist bei dieser Ausführungsform der Erfindung die Flachleiterkonstruktion einen Stützleiter 41 zwischen dem Sensorchip 1 und einem weiteren Halbleiterchip auf, sodass die mechanisch empfindlichen Bonddrahtverbindungen 19 zwischen beiden Halbleiterchips verkürzt werden können. Auch in dieser Ausführungsform der Erfindung wurden zunächst sämtliche Komponenten in die Kunststoffgehäusemasse 8 eingebettet und schließen nur der Bereich der mikromechanischen Struktur des Sensorchips freigelegt, der für eine empfindliche Messung von mechanischen Schwingungen in der Umgebung 11 frei bleiben soll.

Figur 10 zeigt einen schematischen Querschnitt durch ein Halbleitermodul 20 gemäß einer vierten Ausführungsform der Erfindung. Die vierte Ausführungsform der Erfindung unterscheidet sich von der dritten Ausführungsform dadurch, dass die Öffnung 9 über dem Sensorbereich 3 des druckempfindlichen Sensorchips 1 mit einem gummielastischen Material 14 teilweise aufgefüllt ist, um die Sensor-Öffnung 9 vor einem Eindringen von Flüssigkeiten und Gasen, wie sie im Motorraum eines KFZ's auftreten, zu schützen.

Figur 11 zeigt einen schematischen Querschnitt durch ein Halbleitermodul 25 gemäß einer fünften Ausführungsform der Erfindung. Diese fünfte Ausführungsform der Erfindung weist die gleichen Komponenten, wie die Ausführungsform gemäß Figur 12 entsprechend dem Stand der Technik auf jedoch in sind diese Komponenten bis auf den sensitiven Bereich des Sensorchips 1 von der nicht transparenten Kunststoffgehäusemasse 8 bedeckt. Durch das Einbringen einer Öffnung 9 in Form eines Laserabtragstrichters 12 über dem sensitiven Bereich 7 des Sensorchips 1 bleiben die übrigen nicht sensitiven Flächen und Komponenten 16 des Halbleitermoduls 25 durch die Kunststoffgehäusemasse 8 vor mechanischen Beschädigungen und thermomechanischen Spannungen geschützt.

### Bezugszeichenliste

- 1: (Halbleiter) -Sensorchip
- 2: Gehäuse
- 3: Sensorbereich
- 4: weitere Komponente des Halbleitermoduls
- 5: Halbleitermodul (1. Ausführungsform)
- 6: elektrische Verbindung
- 7: nicht sensitive Bereiche des Sensorchips
- 8: nicht transparente Kunststoffgehäusemasse
- 9: Öffnung
- 10: Halbleitermodul (2. Ausführungsform)
- 11: Umgebung
- 12: Laserabtragstrichter
- 13: transparentes Material
- 14: gummielastisches und transparentes Material
- 15: Halbleitermodul (3. Ausführungsform)
- 16: Komponenten des Halbleitermoduls beispielsweise Chips, wie Sensorchips Halbleiterchips und/oder passive Bauelemente
- 17: Chipinsel
- 18: innerer Flachleiter
- 19: Bonddrahtverbindung
- 20: Halbleitermodul (4. Ausführungsform)
- 21: Kontaktflächen
- 22: aktive Oberseite der Chips
- 23: Kontaktanschlussflächen
- 24: Außenflachleiter
- 25: Halbleitermodul (5. Ausführungsform)
- 26: Außenkontakt
- 27: Lasergerät
- 28: Spiegeltrommel
- 29: polygonaler Querschnitt
- 30: Halbleitermodul (Stand der Technik)
- 31: Längsachse
- 32: Hochachse
- 33: Halbleitermodulposition
- 34: Flachleiterrahmen
- 35: Lotschicht
- 36: Rückseite der Halbleiterchips
- 37: Bondverbindung von Halbleiterchip zu Halbleiterchip
- 38: Laserstrahl
- 39: Laserstrahlbereich
- 40: Kavität
- 41: Stützer

- A: Pfeilrichtung
- B: Pfeilrichtung

## Patentansprüche

1. Halbleitermodul mit einem Halbleiter-Sensorchip (1) und einem Gehäuse (2), wobei der Sensorchip (1) einen Sensorbereich (3) aufweist und die nicht sensitiven Bereiche (7) des Sensorchips (1) in einer nicht transparenten Kunststoffgehäusemasse (8) eingebettet sind und der Sensorbereich (3) des Sensorchips (1) über eine Öffnung (9) in der nicht transparenten Kunststoffgehäusemasse (8) mit der Umgebung (11) in Wirkverbindung steht,
**dadurch gekennzeichnet, dass**
die Öffnung (9) einen Laserabtragstrichter (12) aufweist und das Halbleitermodul (5) eine weitere Komponente (4) in Form eines Halbleiterchips oder eines passiven Bauelementes umfasst, die mit dem Sensorchip (1) über elektrische Verbindungen (6) in Weiterverbindung steht, wobei die weitere Komponente (4) sowie die elektrischen Verbindungen (6) in der nicht transparenten Kunststoffgehäusemasse (8) eingebettet sind.

2. Halbleitermodul nach Anspruch 1,
**dadurch gekennzeichnet, dass**
der Laserabtragstrichter (12) mit einem transparenten Material (13) teilweise aufgefüllt ist.

3. Halbleitermodul nach Anspruch 1 oder nach Anspruch 2,
**dadurch gekennzeichnet, dass**
der Laserabtragstrichter (12) mit einem gummielastischen und transparenten Material (14) teilweise aufgefüllt ist.

4. Halbleitermodul nach einem der vorhergehenden Ansprüche,
**dadurch gekennzeichnet, dass**
der Sensorchip (1) und die weitere Komponente (4) stoffschlüssig auf Chipinseln (17) von inneren Flachleitern (18) fixiert sind.

5. Halbleitermodul nach einem der Ansprüche 1 bis 3,
**dadurch gekennzeichnet, dass**
der Sensorchip (1) und die weitere Komponente (4) stoffschlüssig auf Chipinseln (17) eines Verdrahtungssubstrats eines BGA- oder LGA-Gehäuses fixiert sind.

6. Halbleitermodul nach Anspruch 4 oder Anspruch 5,
**dadurch gekennzeichnet, dass**
die elektrischen Verbindungen (6) Bonddrahtverbindungen (19) aufweisen, welche Kontaktflächen (21) der aktiven Oberseiten (22) des Sensochips (1) und der weiteren Komponente (4) mit Kontaktanschlussflächen (23) auf den inneren Flachleitern (18) oder auf dem Verdrahtungssubstrat verbinden.

7. Halbleitermodul nach Anspruch 4 oder Anspruch 6,
**dadurch gekennzeichnet, dass**
die inneren Flachleiter (18) als Aussenflachleiter (24) aus der Kunststoffgehäusemasse (8) herausragen.

8. Halbleitermodul nach Anspruch 5 oder Anspruch 6,
**dadurch gekennzeichnet, dass**
das Verdrahtungssubstrat auf seiner Oberseite den Sensorchip (1) und die weitere Komponente (4) aufweist und auf seiner Unterseite Lotbälle als Aussenkontakte besitzt.

9. Halbleitermodul nach einem der Ansprüche 4 bis 8, **dadurch gekennzeichnet, dass**
das Halbleitermodul (5) als stoffschlüssige Verbindung des Sensorchips (1) und der weiteren Komponente (4) eine eutektische Lötverbindung aufweist.

10. Halbleitermodul nach einem der Ansprüche 4 bis 8,
**dadurch gekennzeichnet, dass**
das Halbleitermodul (5) als stoffschlüssige Verbindung des Sensorchips (1) und der weiteren Komponente (4) eine Diffusionslötverbindung aufweist.

11. Halbleitermodul nach einem der Ansprüche 4 bis 8, **dadurch gekennzeichnet, dass**
das Halbleitermodul (5) als stoffschlüssige Verbindung des Sensorchips (1) und der weiteren Komponente (4) eine Lotpastenverbindung aufweist.

12. Verwendung des Halbleitermoduls (5) gemäss einem der vorhergehenden Ansprüche als optischen Sensor und/oder optischen Empfänger in der KFZ-Technik.

13. Verwendung gemäß Anspruch 12, **dadurch gekennzeichnet, dass** das Halbleitermodul als optischer Sensor und/oder optischer Empfänger in einem Glasfaserkabelbaum von KFZs verwendet wird.

14. Verwendung des Halbleitermoduls (5) gemäss einem der vorhergehenden Ansprüche, als Druck- oder Temperatursensor in der KFZ-Technik.

15. Verfahren zur Herstellung eines Halbleitermoduls (5) mit einem Halbleiter-Sensorchip (1) und einem Gehäuse (2), wobei das Verfahren folgende Verfahrensschritte aufweist:
- Herstellen eines Systemträgers mit Halbleitermodulposition (33) und Kontaktanschlussflächen (23) für elektrische Verbindungen (6) zu Außenkontakten (26) für mindestens ein Halbleitermodul (5),
- Aufbringen von einem Halbleiter-Sensorchip (1) mit einem Sensorbereich (3) und mindestens einer weiteren Komponente (4) des Halbleitermoduls (5) in Form eines Halbleiterchips oder eines passiven Bauelementes auf den Systemträger, wobei der Sensorchip (1) und die weitere Komponente (4) stoffschlüssig mit dem Systemträger verbunden werden,
- Herstellen von elektrischen Verbindungen zwischen Kontaktflächen (21) des Sensorchips (1) und Kontaktanschlussflächen (23) des Systemträgers, zwischen Kontaktflächen (21) der weiteren Komponente (4) und Kontaktanschlussflächen (23) des Systemträgers sowie zwischen Kontaktflächen (21) des Sensorchips (1) und Kontaktflächen (21) der weiteren Komponente (4),
- Aufbringen einer nicht transparenten Kunststoffgehäusemasse (8) auf den Systemträger unter Einbetten des Sensorchips (1) und der weiteren Komponente (4) sowie der elektrischen Verbindungen (6) in der Kunststoffgehäusemasse (8),
- Freilegen des Sensorbereichs (3) des Halbleiter-Sensorchips (1), wobei in der Kunststoffgehäusemasse (8) mittels Laserabtragstechnik ein Laserabtragstrichter (12) zum Sensorbereich gebildet wird.

16. Verfahren nach Anspruch 15,
**dadurch gekennzeichnet, dass**
für einen Laserabtrag ein Lasergerät (27) und eine Spiegeltrommel (28) mit polygonalem Querschnitt (29) eingesetzt wird, wobei die Spiegeltrommel (28) um eine horizontale Längsachse (31) gedreht wird, während das Lasergerät (27) oder ein Planspiegel im Laserstrahl (38) um eine Hochachse (32) geschwenkt wird, um den Laserstrahl entlang der Spiegeltrommellängserstreckung abzulenken, und um somit durch eine flächige Abtastung eine Öffnung (9) über dem Sensorbereich (3) herzustellen.

17. Verfahren nach Anspruch 15 oder Anspruch 16,
**dadurch gekennzeichnet, dass**
als Systemträger ein Nutzen eingesetzt wird.

18. Verfahren nach Anspruch 15 oder Anspruch 16,
**dadurch gekennzeichnet, dass**
als Systemträger ein Flachleiterrahmen (34) eingesetzt wird.

## Claims

1. Semiconductor module with a semiconductor sensor-chip (1) and a housing (2), wherein the sensor-chip (1) has a sensor region (3) and the non-sensing regions (7) of the sensor-chip (1) are embedded in a non-transparent plastic housing body (8) and the sensor region (3) of the sensor-chip (1) is functionally coupled with the surroundings (11) via an opening (9) in the non-transparent plastic housing body (8),
**characterized in that**
the opening (9) has a laser removal funnel (12) and the semiconductor module (5) comprises an additional component (4) in the form of a semiconductor chip or of a passive component, which is further connected to the sensor-chip (1) via electrical connections (6), wherein the additional component (4) and the electrical connections (6) are embedded in the non-transparent plastic housing body (8).

2. Semiconductor module according to claim 1,
**characterized in that**
the laser removal funnel (12) is partially filled with a transparent material (13).

3. Semiconductor module according to claim 1 or claim 2,
**characterized in that**
the laser removal funnel (12) is partially filled with a rubber-elastic and transparent material (14).

4. Semiconductor module according to one of the previous claims,
**characterized in that**
the sensor-chip (1) and the additional component (4) are bonded with material connection on chip islands (17) of internal flat conductors (18).

5. Semiconductor module according to one of claims 1 to 3,
**characterized in that**
the sensor-chip (1) and the additional component (4) are bonded with material connection on chip islands (17) of a wiring substrate of a BGA- or LGA-housing.

6. Semiconductor module according to claim 4 or claim 5,
**characterized in that**
the electrical connections (6) have bonding-wire connections (19), which connect contact areas (21) of the active upper sides (22) of the sensor-chip (1) and of the additional component (4) to contact connection areas (23) on the internal flat conductors (18) or on the wiring substrate.

7. Semiconductor module according to claim 4 or claim 6,
**characterized in that**
the internal flat conductors (18) project out of the plastic housing body (8) as exterior flat conductors (24).

8. Semiconductor module according to claim 5 or claim 6,
**characterized in that**
the wiring substrate comprises on its upper side the sensor-chip (1) and the additional component (4), and on its lower side has soldering balls as external contacts.

9. Semiconductor module according to one of claims 4 to 8,
**characterized in that**
as a material connection of the sensor-chip (1) and the additional component (4) the semiconductor module (5) has a eutectic solder joint.

10. Semiconductor module according to one of claims 4 to 8,
**characterized in that**
as a material connection of the sensor-chip (1) and the additional component (4) the semiconductor module (5) has a diffusion solder joint.

11. Semiconductor module according to one of claims 4 to 8,
**characterized in that**
as a material connection of the sensor-chip (1) and the additional component (4) the semiconductor module (5) has a solder paste joint.

12. Use of the semiconductor module (5) according to one of the previous claims as an optical sensor and/or optical receiver in vehicle engineering.

13. Use according to claim 12,
**characterized in that**
the semiconductor module is used as an optical sensor and/or optical receiver in an optical-fibre cable harness of vehicles.

14. Use of the semiconductor module (5) according to one of the previous claims, as a pressure or temperature sensor in vehicle engineering.

15. Method for manufacturing a semiconductor module (5) with a semiconductor sensor-chip (1) and a housing (2), wherein the method has the following method steps:
- manufacturing a system carrier with semiconductor module position (33) and contact connection surfaces (23) for electrical connections (6) to external contacts (26) for at least one semiconductor module (5),
- applying a semiconductor sensor-chip (1) with a sensor region (3) and at least one additional component (4) of the semiconductor module (5), in the form of a semiconductor chip or a passive component, onto the system carrier, wherein the sensor-chip (1) and the additional component (4) are joined to be bonded with material connection to the system carrier,
- manufacturing electrical connections between contact surfaces (21) of the sensor-chip (1) and contact connection surfaces (23) of the system carrier, between contact surfaces (21) of the additional component (4) and contact connection surfaces (23) of the system carrier, as well as between contact surfaces (21) of the sensor-chip (1) and contact surfaces (21) of the additional component (4),
- applying a non-transparent plastic housing body (8) onto the system carrier with the sensor-chip (1) and the additional component (4) as well as the electrical connections (6) being embedded in the plastic housing body (8),
- exposing the sensor region (3) of the semiconductor sensor-chip (1), wherein in the plastic housing body (8) by laser removal technology a laser removal funnel (12) is formed towards the sensor region.

16. Method according to claim 15,
**characterized in that**
for laser removal a laser device (27) and a mirror drum (28) with polygon-shaped cross-section (29) are employed, wherein the mirror drum (28) is rotated about a horizontal longitudinal axis (31), while the laser device (27) or a plane mirror is pivoted in the laser beam (38) about a vertical axis (32), in order to deflect the laser beam along the longitudinal extension of the mirror drum, and in order thereby to produce an opening (9) over the sensor region (3) by an areal scanning operation.

17. Method according to claim 15 or claim 16,
**characterized in that**
a panel is used as system carrier.

18. Method according to claim 15 or claim 16,
**characterized in that**
a flat conductor frame (34) is employed as system carrier.

## Revendications

1. Module à semi-conducteur avec une puce de capteur à semi-conducteur (1) et un boîtier (2), la puce de capteur (1) comprenant une partie de capteur (3), les parties non sensibles (7) de la puce de capteur (1) étant intégrées dans une masse de boîtier en matière plastique non trans-parente (8) et la partie de capteur (3) de la puce de capteur (1) étant en liaison fonction-nelle avec l'environnement (11) par l'inter-médiaire d'une ouverture (9) dans la masse du boîtier en matière plastique non transparente (8), **caractérisé en ce que** l'ouverture (9) comprend un cône d'extraction au laser (12) et le module de semi-conducteur (5) comprend un composant supplémentaire (4) sous la forme d'une puce à semi-conducteur ou d'un composant passif qui est relié avec la puce de capteur (1) par l'intermédiaire de liaisons électriques (6), le composant supplémentaire (4) ainsi que les liaisons électriques (6) étant intégrés dans la masse du boîtier en matière plastique non trans-parente (8).

2. Module à semi-conducteur selon la revendication 1, **caractérisé en ce que** le cône d'extraction au laser (12) est partiellement rempli avec un matériau transparent (13).

3. Module à semi-conducteur selon la revendication 1 ou selon la revendication 2, **caractérisé en ce que** le cône d'extraction au laser (12) est partiellement rempli avec un matériau de type caoutchouc élastique et transparent (14).

4. Module à semi-conducteur selon l'une des revendications précédentes, **caractérisé en ce que** la puce de capteur (1) et le composant supplémentaire (4) sont fixés par liaison de matière sur des îlots (17) par des conducteurs plats internes (18).

5. Module à semi-conducteur selon l'une des revendications 1 à 3, **caractérisé en ce que** la puce de capteur (1) et le composant supplémen-taire (4) sont fixés avec une liaison de matière sur des îlots (17) d'un substrat de câblage d'un boîtier BGA ou LGA.

6. Module à semi-conducteur selon la revendication 4 ou la revendication 5, **caractérisé en ce que** les liaisons électriques (6) comprennent des liaisons par fils de connexion (19) qui relient les surfaces de contact (21) des côtés supérieurs actifs (22) de la puce de capteur (1) avec les surface de branchement par contact (23) sur les conducteurs plats internes (18) ou sur le substrat de câblage.

7. Module à semi-conducteur selon la revendication 4 ou la revendication 6, **caractérisé en ce que** les conducteurs plats internes (18) dépassent de la masse du boîtier en matière plastique (8) sous la forme de conducteurs plats externes (24).

8. Module à semi-conducteur selon la revendication 5 ou la revendication 6, **caractérisé en ce que** le substrat de câblage comprend, sur son côté supérieur, la puce de capteur (1) et le compo-sant supplémentaire (4) et comprend, sur son côté inférieur, des billes de brasage en tant que contacts externes.

9. Module à semi-conducteur selon l'une des revendications 4 à 8, **caractérisé en ce que** le module à semi-conducteur (5) comprend une liai-son par brasage eutectique en tant que liaison de matière de la puce de capteur (1) et du composant supplémentaire (4).

10. Module à semi-conducteur selon l'une des revendications 4 à 8, **caractérisé en ce que** le module à semi-conducteur (5) comprend une liai-son par brasage par diffusion en tant que liai-son de matière de la puce de capteur (1) et du composant supplémentaire (4).

11. Module à semi-conducteur selon l'une des revendications 4 à 8, **caractérisé en ce que** le module à semi-conducteur (5) comprend une liai-son par pâte de brasage en tant que liaison de matière de la puce de capteur (1) et du composant supplémentaire (4).

12. Utilisation du module à semi-conducteur (5) selon l'une des revendications précédentes, en tant que capteur optique et/ou récepteur optique dans l'industrie automobile.

13. Utilisation selon la revendication 12, **caractérisé en ce que** le module à semi-conducteur est utilisé en tant que capteur optique et/ou récepteur optique dans un faisceau de câbles à fibres de verre d'automobile.

14. Utilisation du module à semi-conducteur (5) selon l'une des revendications précédentes en tant que capteur de pression ou de température dans l'industrie automobile.

15. Procédé de fabrication d'un module à semi-conducteur (5) avec une puce de capteur à semi-conducteur (1) et un boîtier (2), le procédé comprenant les étapes suivantes :
■ fabrication d'un support de système avec la position du module à semi-conducteur (33)et des surfaces de branchement par contact (23) pour des liaisons électriques (6) avec des contacts externes (26) pour au moins un module à semi-conducteur (5),
■ montage d'une puce de capteur à semi-conducteur (1) avec une partie de capteur (3) et au moins un composant supplémentaire (4) du module à semi-conducteur (5) sous la forme d'une puce à semi-conducteur ou d'un composant passif sur le support de système, la puce de capteur (1) et le composant supplémentaire (4) étant reliés par une liaison de matière avec le support de système,
■ fabrication de liaisons électriques entre les surfaces de contact (21) de la puce de capteur (1) et les surfaces de branchement par contact (23) du support de système, entre les surfaces de contact (21) du composant supplémentaire (4) du support de système, entre les surfaces de contact (21) du composant supplémentaire (4), ainsi qu'entre les surfaces de contact (21) de la puce de capteur (1) et les surfaces de contact (21) du composant supplémentaire (4),
■ montage d'une masse de boîtier en matière plastique non transparente (8) sur le support de système grâce à l'intégration de la puce de capteur (1) et du composant supplémentaire (4) ainsi que des liaisons électriques (6) dans la masse du boîtier en matière plastique (8),
■ libération de la partie de capteur (3) de la puce de capteur à semi-conducteur (1), un cône d'extraction au laser (12) étant formé en une partie de capteur dans la masse de boîtier en matière plastique (8) à l'aide d'une technique d'extraction au laser.

16. Procédé selon la revendication 15, caracté-risé en ce que, pour une extraction au laser, un appareil laser (27) et un tambour réfléchissant (28) avec une section polygonale (29) sont utilisés, le tambour réfléchissant (28) étant mis en rotation autour d'un axe longitudinal horizontal (31) tandis que l'appareil laser (27) ou un miroir plan est pivoté autour d'un axe (32) dans le rayon laser (38) afin de dévier le rayon laser le long de l'extension longitudinale du tambour réfléchissant et afin de réaliser ainsi, grâce à une détection superficielle, une ouverture (9) sur la partie de capteur (3).

17. Procédé selon la revendication 15 ou la revendication 16, **caractérisé en ce qu'**une pièce est utilisée en tant que support de système.

18. Procédé selon la revendication 15 ou la revendication 16, **caractérisé en ce qu'**un cadre à conducteur plat (34) est utilisé en tant que support de système.
